# FASCICULE DE BREVET EUROPEEN

(11) **EP 3 971 597 B1**
(45) Date de publication et mention de la délivrance du brevet: **28.08.2024**
(21) Numéro de dépôt: 21196590.0
(22) Date de dépôt: 14.09.2021
(51) Int. Cl.: G01R 31/66, H04B 7/08, G01R 27/00

(54) **PROCEDE ET DISPOSITIF DE DETECTION DE LA PRESENCE D'UNE ANTENNE EXTERNE ET DE CONNEXION DE L'ANTENNE EXTERNE A UN MODULE RADIO**
VERFAHREN UND VORRICHTUNG ZUR ERKENNUNG DER PRÄSENZ EINER EXTERNEN ANTENNE UND DER VERBINDUNG DER EXTERNEN ANTENNE AN EIN FUNKMODUL
METHOD AND DEVICE FOR DETECTING THE PRESENCE OF AN EXTERNAL ANTENNA AND CONNECTION OF THE EXTERNAL ANTENNA TO A RADIO MODULE

(30) Priorité: 17.09.2020 FR 2009407
(43) Date de publication de la demande: 23.03.2022
(73) Titulaire: Delta Dore, 35270 Bonnemain (FR)
(72) Inventeur: GUILLOT, Christophe, 35270 BONNEMAIN (FR); FLAUX, Philippe, 35270 BONNEMAIN (FR); GIOT, Lionel, 35270 BONNEMAIN (FR)
(74) Mandataire: Cabinet Le Guen Maillet

(56) Documents cités:
- WO-A1-2008/118060
- WO-A1-2016/127558
- WO-A2-2005/094154
- JP-A- 2015 211 274
- JP-A- H1 198 048
- FORD R ET AL: "METHOD FOR AUTOMATIC RF SWITCHING BASED ON PRESENCE OF ANTENNA", MOTOROLA TECHNICAL DEVELOPMENTS, MOTOROLA INC. SCHAUMBURG, ILLINOIS, US, vol. 19, 1 June 1993 (1993-06-01), pages 25 - 26, XP000361458, ISSN: 0887-5286
- QUECTEL: "M10 Antenna Detection Application Circuit", 26 June 2012 (2012-06-26), EddyWireless website, XP055671945, Retrieved from the Internet <URL:https://www.eddywireless.com/yahoo_site_admin/assets/docs/Quectel_GSM_Antanna_Detection_Application_note.175173113.pdf> [retrieved on 20200227]

## Description

### DOMAINE TECHNIQUE

La présente invention concerne un procédé et un dispositif de détection de la présence d'une antenne externe et de connexion de l'antenne externe à un module radio.

### ETAT DE LA TECHNIQUE ANTERIEURE

L'installation électrique d'un bâtiment comporte un tableau électrique ou tableau de répartition qui comporte différents types d'appareillage associés à un ou plusieurs circuits électriques de départ alimentés par un ou plusieurs circuits électriques d'arrivée et des équipements de protection.

La domotique permet aujourd'hui de commander différents équipements à distance, par exemple à l'aide d'un téléphone intelligent (Smartphone en anglais). Ces équipements sont par exemple et non limitativement une centrale d'alarme, la commande de dispositifs d'occultation d'ouvertures, un système de régulation de la température du bâtiment.

Afin de pouvoir communiquer à distance, des passerelles sont reliées par un module radio aux équipements commandés à distance et/ou à un réseau de communication externe.

De manière à centraliser les équipements électriques en un unique point, le besoin de placer le module radio dans le tableau électrique est apparu.

Dans certaines installations, la localisation du tableau électrique dans le bâtiment, la nature des matériaux constituant le tableau électrique et son enveloppe, les différents appareillages qui sont compris dans le tableau électrique et/ou le câblage du tableau électrique perturbent la qualité de réception et/ou de transmission de l'antenne radio comprise dans le module radio.

Le document intitulé « method for automatic RF switching based on presence of antenna » et les demandes de brevet JP H11 98048, JP 2015 211274, WO 2016/127558, WO 2008/118060 et WO 2005/094154 divulguent un dispositif de détection de la présence d'une antenne externe et de connexion de l'antenne externe à un module radio comportant une antenne interne.

La présente invention vise ainsi à proposer un procédé et un dispositif de détection de la présence d'une antenne externe et de connexion de l'antenne externe à un module radio compris dans un tableau électrique.

### EXPOSE DE L'INVENTION

A cette fin, selon un premier aspect, l'invention propose un dispositif de détection de la présence d'une antenne externe et de connexion de l'antenne externe à un module radio comportant une antenne interne et un connecteur pour une connexion de l'antenne externe à un module radio, caractérisé en ce qu'une impédance est disposée aux bornes de l'antenne externe et en ce que le dispositif comporte :
- des moyens de détection d'une valeur de l'impédance à son entrée,
- des moyens de commande du basculement d'un commutateur dans une position dans laquelle l'antenne externe est reliée au module radio si l'impédance à son entrée est comprise entre une première ou une seconde valeurs prédéterminées,
- des moyens de commande du basculement du commutateur dans une position dans laquelle l'antenne interne est reliée au module radio si l'impédance à son entrée est inférieure à la première valeur prédéterminée ou supérieure à la seconde valeur prédéterminée.

L'invention concerne aussi un procédé de détection de la présence d'une antenne externe et de connexion de l'antenne externe à un module radio comportant une antenne interne et un connecteur pour une connexion de l'antenne externe à un module radio, caractérisé en ce qu'une impédance est disposée aux bornes de l'antenne externe et en ce que le procédé comporte les étapes, exécutées par un dispositif de détection de la présence d'une antenne externe et de connexion de l'antenne externe à un module radio, de :
- détection d'une valeur de l'impédance à une entrée du dispositif de détection de la présence d'une antenne externe et de connexion de l'antenne externe à un module radio comportant une antenne interne,
- commande du basculement d'un commutateur dans une position dans laquelle l'antenne externe est reliée au module radio si l'impédance à l'entrée du dispositif de détection de la présence d'une antenne externe et de connexion de l'antenne externe à un module radio est comprise entre une première ou une seconde valeurs prédéterminées,
- commande du basculement du commutateur dans une position dans laquelle l'antenne interne est reliée au module radio si l'impédance à l'entrée du dispositif de détection de la présence d'une antenne externe et de connexion de l'antenne externe à un module radio est inférieure à la première valeur prédéterminée ou supérieure à la seconde valeur prédéterminée.

Ainsi, il est possible de garantir une bonne qualité d'émission et/ou de réception de signaux radio par le module radio en permettant l'ajout d'une antenne externe qui est automatiquement connectée au module radio lorsque l'antenne externe est placée.

Selon un mode particulier de l'invention, le dispositif est compris dans un tableau électrique d'un bâtiment.

Ainsi la présente invention tire avantage de la présence d'un tableau électrique dans un bâtiment. De l'énergie électrique étant présente dans le tableau électrique, l'installation du module radio et sa fourniture en énergie électrique sont simplifiées.

De plus, dans le cas particulier des logements locatifs, la localisation dans le tableau électrique permet de réduire les risques de détérioration ou de déplacement intempestif du module radio lors d'un changement de locataire.

Selon un mode particulier de l'invention, l'impédance disposée aux bornes de l'antenne externe est une résistance.

Ainsi, la présente invention permet d'éviter qu'une antenne non dédiée à la présente invention puisse être connectée au module radio.

Selon un mode particulier de l'invention, les moyens de détection d'une variation de l'impédance sont constitués d'un comparateur et d'une résistance.

L'invention concerne aussi les programmes d'ordinateur stockés sur un support d'informations, lesdits programmes comportant des instructions permettant de mettre en oeuvre les procédés précédemment décrits, lorsqu'ils sont chargés et exécutés par un système informatique.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] représente un bâtiment dans lequel la présente invention est implémentée ;
[Fig. 2] représente un exemple d'architecture d'un dispositif de détection de la présence d'une antenne externe et de connexion de l'antenne externe à un module radio selon la présente invention ;
[Fig. 3] représente un exemple d'algorithme exécuté par le dispositif de détection de la présence d'une antenne externe et de connexion de l'antenne externe à un module radio selon la présente invention.

### EXPOSE DETAILLE DE MODES DE REALISATION

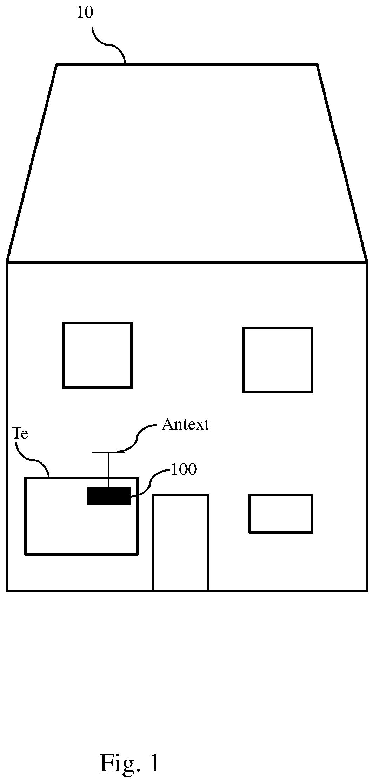

La Fig. 1 représente un bâtiment dans lequel la présente invention est implémentée.

Le bâtiment 10 comporte un système de domotique permettant de contrôler l'ouverture de dispositifs d'occultation de fenêtres et/ou de contrôler des moyens de chauffage du bâtiment et/ou de contrôler un système d'alarme anti-intrusion...

Le système de domotique est relié à un module radio par l'intermédiaire d'un dispositif 100 de détection de la présence d'une antenne externe Antext et de connexion de l'antenne externe Antext au module radio. Le dispositif 100 de détection de la présence d'une antenne externe et de connexion de l'antenne externe au module radio comporte une antenne interne et peut être connecté à l'antenne externe Antext. L'antenne externe Antext est par exemple accordée à la fréquence de 869MHz ou 160 MHz, ou 433 MHz ou 2,45GHz et comporte, selon l'invention, un composant présentant une impédance Z caractéristique en DC prédéterminée tout en ayant une impédance non influente à la fréquence d'accord de l'antenne externe Antext. Par exemple, le composant est une résistance de 10Kohms. Le composant présente à la fréquence d'accord de l'antenne une impédance par exemple supérieure à deux cents fois l'impédance de l'antenne Antext.

Le dispositif 100 de détection de la présence d'une antenne externe et de connexion de l'antenne externe au module radio est placé dans un tableau électrique Te du bâtiment 100. Le bâtiment 10 est dans la zone de couverture d'un premier réseau de communication radio. Le premier réseau de communication est un réseau domestique tel que par exemple un réseau de communication commercialisé par la demanderesse sous le nom commercial X3D ou un réseau de communication de type Zigbee.

Le bâtiment 10 est dans la zone de couverture d'un second réseau de communication radio. Le second réseau de communication est un réseau étendu à basse consommation tel que par exemple un réseau de type LoRa ou Sigfox ou un réseau de télécommunication cellulaire. Certaines parties du bâtiment 10 ne sont pas dans la zone de couverture du second réseau de communication radio. Lorsque le tableau électrique n'est pas dans la zone de couverture du second réseau de communication radio, la qualité de réception des signaux radio du second réseau de communication ne permet pas de communiquer avec le second réseau de communication radio. Il est alors nécessaire de placer une antenne radio Antext à l'extérieur du tableau électrique et dans la zone de couverture du second réseau de communication radio.

Selon la présente invention, le dispositif de détection de la présence d'une antenne externe et de connexion de l'antenne externe à un module radio comporte :
- des moyens de détection d'une valeur de l'impédance à son entrée,
- des moyens de commande du basculement d'un commutateur dans une position dans laquelle l'antenne externe est reliée au module radio si l'impédance à son entrée est comprise entre une première ou une seconde valeurs prédéterminées,
- des moyens du commande du basculement du commutateur dans une position dans laquelle l'antenne interne est reliée au module radio si l'impédance à son entrée est inférieure à la première valeur prédéterminée ou supérieure à la seconde valeur prédéterminée.

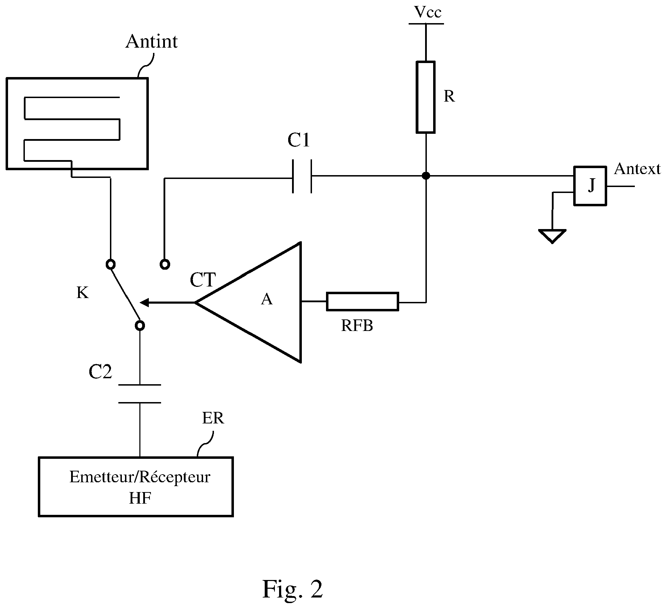

La Fig. 2 représente un exemple d'architecture du dispositif de détection de la présence d'une antenne externe et de connexion de l'antenne externe à un module radio selon la présente invention.

Le dispositif 100 de détection de la présence d'une antenne externe et de connexion de l'antenne externe à un module radio comporte un connecteur J auquel une antenne externe Antext est connectée ou non, un commutateur K et une antenne interne Antint.

L'antenne externe Antext est par exemple une antenne dipôle aux bornes de laquelle est connectée une résistance présentant une impédance de 10K Ohms.

Le dispositif 100 de détection de la présence d'une antenne externe et de connexion de l'antenne externe à un module radio comporte des moyens de détection d'une valeur de l'impédance à son entrée. Si l'impédance à son entrée est comprise entre une première ou une seconde valeurs prédéterminées, le dispositif 100 de détection de la présence d'une antenne externe et de connexion de l'antenne externe à un module radio commande le basculement du commutateur K dans une position dans laquelle l'antenne externe Antext est reliée à un module radio ER.

Si l'impédance à l'entrée du dispositif 100 de détection de la présence d'une antenne externe et de connexion de l'antenne externe à un module radio est inférieure à la première valeur prédéterminée ou supérieure à la seconde valeur prédéterminée, le dispositif 100 de détection de la présence d'une antenne externe et de connexion de l'antenne externe à un module radio commande le basculement du commutateur K dans une position dans laquelle l'antenne interne Antint est reliée au module radio ER.

Les moyens de détection d'une valeur de l'impédance à l'entrée du dispositif 100 de détection de la présence d'une antenne externe et de connexion de l'antenne externe à un module radio sont constitués d'un comparateur A et d'une résistance R.

Dans un mode particulier, les moyens de détection d'une valeur de l'impédance comportent des moyens de blocage des fréquences HF. Les moyens sont par exemple une résistance d'une valeur de quelques kilo Ohms ou d'une inductance RFB qui a par exemple une valeur de 100nH et présente une résistance série de quelques milli Ohms pour une fréquence de résonnance de 868 MHz ou une valeur de 33nH pour une fréquence de résonnance de 2,45 GHz.

L'inductance RFB permet d'atténuer les signaux haute fréquence présents au niveau de l'antenne externe Antext.

La résistance R a par exemple une valeur égale à 10KOhms.

Le comparateur A est par exemple un amplificateur-comparateur permettant de positionner un signal CT en fonction de la tension continue présente sur son entrée. Si l'antenne externe Antext est connectée au dispositif 100 de détection de la présence d'une antenne externe et de connexion de l'antenne externe à un module radio par l'intermédiaire du connecteur J, la résistance R et l'impédance Z présente sur l'antenne extérieure Antext forment un pont diviseur de tension que le comparateur A détecte. Le comparateur A positionne en conséquence le commutateur K de manière à ce que l'antenne extérieure Antext soit reliée au module radio.

Si l'antenne externe Antext n'est pas connectée au connecteur J, l'impédance devient alors quasi infinie et la valeur de la tension en entrée du comparateur A devient différente et le comparateur A positionne en conséquence le commutateur K de manière à ce que l'antenne interne Antint soit reliée au module radio ER appelé aussi émetteur récepteur HF.

Si un bouchon 50Ω est connecté au connecteur J, le bouchon a une impédance très faible par rapport à la résistance de 10KOhm, la valeur du pont diviseur formé avec la résistance R devient différente des deux cas précédents et le comparateur A positionne en conséquence le commutateur K de manière à ce que l'antenne interne Antint soit reliée au module radio ER.

Une première terminaison du connecteur J est reliée à la masse du dispositif 100 de détection de la présence d'une antenne externe et de connexion de l'antenne externe à un module radio. Une seconde terminaison du connecteur J est reliée à une première terminaison de la résistance R, à une première terminaison de l'inductance RFB et à une première terminaison d'un condensateur C1.

Une seconde terminaison de l'inductance RFB est reliée à l'entrée du comparateur A, une seconde terminaison de la résistance R est reliée à l'alimentation Vcc du dispositif 100 de détection de la présence d'une antenne externe et de connexion de l'antenne externe à un module radio.

Le module radio HF est relié à une première terminaison d'un condensateur C2. Une seconde terminaison du condensateur C2 est reliée à une première terminaison du commutateur K. Le commutateur K est commandé par le signal de sortie CT du comparateur A.

Une seconde terminaison du commutateur K est reliée à l'antenne interne Antint.

Une troisième terminaison du commutateur K est reliée à une seconde terminaison du condensateur C1.

Les condensateurs C1 et C2 ont pour fonction de laisser passer le signal HF tout en bloquant la composante continue du signal.

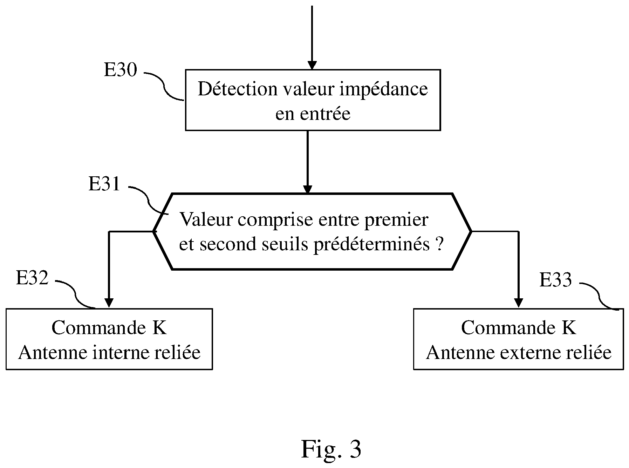

La Fig. 3 représente un exemple d'algorithme exécuté par le dispositif de détection de la présence d'une antenne externe et de connexion de l'antenne externe à un module radio selon la présente invention.

A l'étape E30, le dispositif de détection de la présence d'une antenne externe et de connexion de l'antenne externe à un module radio détecte une valeur de l'impédance à son entrée,

A l'étape E31, le dispositif de détection de la présence d'une antenne externe et de connexion de l'antenne externe à un module radio vérifie si l'impédance à son entrée est comprise entre une première ou une seconde valeurs prédéterminées.

Dans l'affirmative, le dispositif de détection de la présence d'une antenne externe et de connexion de l'antenne externe à un module radio passe à l'étape E33. Dans la négative, le dispositif de détection de la présence d'une antenne externe et de connexion de l'antenne externe à un module radio passe à l'étape E32.

A l'étape E33, le dispositif de détection de la présence d'une antenne externe et de connexion de l'antenne externe à un module radio commande le basculement du commutateur K dans une position dans laquelle l'antenne externe Antext est reliée au module radio ER.

A l'étape E32, le dispositif de détection de la présence d'une antenne externe et de connexion de l'antenne externe à un module radio commande le basculement du commutateur K dans une position dans laquelle l'antenne interne Antint est reliée au module radio ER.

## Revendications

1. Dispositif de détection de la présence d'une antenne externe (Antext) et de connexion de l'antenne externe à un module radio comportant une antenne interne (Antint) et un connecteur (J) pour une connexion de l'antenne externe à un module radio (ER), avec une impédance disposée aux bornes de l'antenne externe (Antext), le dispositif comportant :
- des moyens de détection d'une valeur d'une impédance à une entrée du dispositif
**caractérisé en ce que** le dispositif comporte en outre :
- des moyens de commande du basculement d'un commutateur (K) dans une position dans laquelle l'antenne externe est reliée au module radio si l'impédance à l'entrée du dispositif est comprise entre une première ou une seconde valeurs prédéterminées,
- des moyens de commande du basculement du commutateur dans une position dans laquelle l'antenne interne (Antint) est reliée au module radio (ER) si l'impédance à l'entrée du dispositif est inférieure à la première valeur prédéterminée ou supérieure à la seconde valeur prédéterminée.

2. Dispositif selon la revendication 1, **caractérisé en ce que** le dispositif est compris dans un tableau électrique d'un bâtiment.

3. Dispositif selon la revendication 1 ou 2, **caractérisé en ce que** l'impédance disposée aux bornes de l'antenne externe est une résistance.

4. Dispositif selon l'une quelconque des revendications 1 à 3, **caractérisé en ce que** les moyens de détection d'une variation de l'impédance sont constitués d'un comparateur et d'une résistance.

5. Procédé de détection de la présence d'une antenne externe et de connexion de l'antenne externe à un module radio comportant une antenne interne (Antint) et un connecteur pour une connexion de l'antenne externe à un module radio, avec une impédance disposée aux bornes de l'antenne externe, le procédé comportant l'étape, exécutée par un dispositif de détection de la présence d'une antenne externe (Antext) et de connexion de l'antenne externe à un module radio, de :
- détection (E30) d'une valeur de l'impédance à une entrée du dispositif de détection de la présence d'une antenne externe et de connexion de l'antenne externe à un module radio comportant une antenne interne (Antint),
le procédé étant en outre **caractérisé par** les étapes de :
- commande (E33) du basculement d'un commutateur dans une position dans laquelle l'antenne externe est reliée au module radio si l'impédance à l'entrée du dispositif de détection de la présence d'une antenne externe et de connexion de l'antenne externe à un module radio est comprise entre une première ou une seconde valeurs prédéterminées,
- commande (E32) du basculement du commutateur dans une position dans laquelle l'antenne interne est reliée au module radio si l'impédance à l'entrée du dispositif de détection de la présence d'une antenne externe et de connexion de l'antenne externe à un module radio est inférieure à la première valeur prédéterminée ou supérieure à la seconde valeur prédéterminée.

## Patentansprüche

1. Vorrichtung zur Erkennung des Vorhandenseins einer externen Antenne (Antext) und zur Verbindung der externen Antenne mit einem Funkmodul, die eine interne Antenne (Antint) und einen Verbinder (J) für eine Verbindung der externen Antenne mit einem Funkmodul (ER) aufweist, mit einer an den Klemmen der externen Antenne (Antext) angeordneten Impedanz, wobei die Vorrichtung aufweist:
- Einrichtungen zur Erkennung eines Werts einer Impedanz an einem Eingang der Vorrichtung,
**dadurch gekennzeichnet, dass** die Vorrichtung außerdem enthält:
- Steuereinrichtungen des Kippens eines Schalters (K) in eine Stellung, in der die externe Antenne mit dem Funkmodul verbunden ist, wenn die Impedanz am Eingang der Vorrichtung zwischen einem ersten oder einem zweiten vorbestimmten Wert liegt,
- Steuereinrichtungen des Kippens des Schalters in eine Stellung, in der die interne Antenne (Antint) mit dem Funkmodul (ER) verbunden ist, wenn die Impedanz am Eingang der Vorrichtung niedriger ist als der erste vorbestimmte Wert oder höher ist als der zweite vorbestimmte Wert.

2. Vorrichtung nach Anspruch 1, **dadurch gekennzeichnet, dass** die Vorrichtung in einer Schalttafel eines Gebäudes enthalten ist.

3. Vorrichtung nach Anspruch 1 oder 2, **dadurch gekennzeichnet, dass** die an den Klemmen der externen Antenne angeordnete Impedanz ein Widerstand ist.

4. Vorrichtung nach einem der Ansprüche 1 bis 3, **dadurch gekennzeichnet, dass** die Erkennungseinrichtungen einer Impedanzänderung aus einem Komparator und einem Widerstand bestehen.

5. Verfahren zur Erkennung des Vorhandenseins einer externen Antenne und zur Verbindung der externen Antenne mit einem Funkmodul, das eine interne Antenne (Antint) und einen Verbinder für eine Verbindung der externen Antenne mit einem Funkmodul aufweist, mit einer an den Klemmen der externen Antenne angeordneten Impedanz, wobei das Verfahren den von einer Erkennungsvorrichtung des Vorhandenseins einer externen Antenne (Antext) und der Verbindung der externen Antenne mit einem Funkmodul ausgeführten Schritt aufweist:
- Erkennung (E30) eines Werts der Impedanz an einem Eingang der Erkennungsvorrichtung des Vorhandenseins einer externen Antenne und der Verbindung der externen Antenne mit einem Funkmodul, die eine interne Antenne (Antint) aufweist,
wobei das Verfahren außerdem durch die Schritte gekennzeichnet ist:
- Steuerung (E33) des Kippens eines Schalters in eine Stellung, in der die externe Antenne mit dem Funkmodul verbunden ist, wenn die Impedanz am Eingang der Erkennungsvorrichtung des Vorhandenseins einer externen Antenne und der Verbindung der externen Antenne mit einem Funkmodul zwischen einem ersten oder einem zweiten vorbestimmten Wert liegt,
- Steuerung (E32) des Kippens des Schalters in eine Stellung, in der die interne Antenne mit dem Funkmodul verbunden ist, wenn die Impedanz am Eingang der Erkennungsvorrichtung des Vorhandenseins einer externen Antenne und der Verbindung der externen Antenne mit einem Funkmodul niedriger ist als der erste vorbestimmte Wert oder höher ist als der zweite vorbestimmte Wert.

## Claims

1. Device for detecting the presence of an external antenna (Antext) and for connecting the external antenna to a radio module comprising an internal antenna (Antint) and a connector (J) for connecting the external antenna to a radio module (ER), with an impedance arranged across the terminals of the external antenna (Antext), the device comprising:
- means for detecting a value of an impedance at an input of the device,
**characterized in that** the device further comprises:
- means for controlling switching of a switch (K) to a position in which the external antenna is connected to the radio module if the impedance at the input of the device is between a first and a second predetermined value,
- means for controlling switching of the switch to a position in which the internal antenna (Antint) is connected to the radio module (ER) if the impedance at the input of the device is lower than the first predetermined value or greater than the second predetermined value.

2. Device according to Claim 1, **characterized in that** the device is contained in an electrical switchboard of a building.

3. Device according to Claim 1 or 2, **characterized in that** the impedance arranged across the terminals of the external antenna is a resistor.

4. Device according to any one of Claims 1 to 3, **characterized in that** the means for detecting a variation in the impedance consist of a comparator and a resistor.

5. Method for detecting the presence of an external antenna and for connecting the external antenna to a radio module comprising an internal antenna (Antint) and a connector for connecting the external antenna to a radio module, with an impedance arranged across the terminals of the external antenna, the method comprising the step, which is executed by a device for detecting the presence of an external antenna (Antext) and for connecting the external antenna to a radio module, of:
- detecting (E30) a value of the impedance at an input of the device for detecting the presence of an external antenna and for connecting the external antenna to a radio module comprising an internal antenna (Antint),
the method being further **characterized by** the steps of:
- controlling (E33) switching of a switch to a position in which the external antenna is connected to the radio module if the impedance at the input of the device for detecting the presence of an external antenna and for connecting the external antenna to a radio module is between a first and a second predetermined value,
- controlling (E32) switching of the switch to a position in which the internal antenna is connected to the radio module if the impedance at the input of the device for detecting the presence of an external antenna and for connecting the external antenna to a radio module is lower than the first predetermined value or greater than the second predetermined value.
